# EUROPÄISCHE PATENTSCHRIFT

(11) **EP 1 894 283 B1**
(45) Veröffentlichungstag und Bekanntmachung des Hinweises auf die Patenterteilung: **24.08.2011**
(21) Anmeldenummer: 06777324.2
(22) Anmeldetag: 14.06.2006
(51) Int. Cl.: H02H 3/33

(54) **FEHLERSTROMANALYSATOR ZUR ERFASSUNG EINES FEHLERSTROMS UND EINRICHTUNG MIT FEHLERSTROMERFASSUNGSFUNKTION**
FAULT CURRENT ANALYSER FOR DETECTING A FAULT CURRENT AND A FAULT CURRENT DETECTION DEVICE
ANALYSEUR DE COURANT DE FUITE DESTINE A DETECTER UN COURANT DE FUITE ET DISPOSITIF PRESENTANT UNE FONCTION DE DETECTION DE COURANT DE FUITE

(30) Priorität: 22.06.2005 DE 102005028881
(43) Veröffentlichungstag der Anmeldung: 05.03.2008
(73) Patentinhaber: SIEMENS AKTIENGESELLSCHAFT, 80333 München (DE)
(72) Erfinder: MARTEL, Jean-Marie, 93053 Regensburg (DE)
(86) Internationale Anmeldenummer: PCT/EP2006/063189
(87) Internationale Veröffentlichungsnummer: WO 2006/136520

(56) Entgegenhaltungen:
- EP-A- 0 575 639
- EP-A- 1 267 467
- WO-A-01/15297

## Beschreibung

Die Erfindung betrifft einen Fehlerstromanalysator zur Erfassung eines Fehlerstroms in einem elektrischen Netz mit mehreren elektrischen Leitern umfassend einen Summenstromwandler, dessen Primärwicklungen durch die elektrischen Leiter gebildet sind, und der sekundärseitig ein Ausgangssignal liefert, und an den Summenstromwandler angeschlossene Auswertemittel zur Auswertung des Ausgangssignals, wobei die Auswertemittel eine Filtereinheit zur Selektion mindestens eines niederfrequenten Teilsignals des Ausgangssignals umfassen. Außerdem betrifft die Erfindung eine Einrichtung mit Fehlerstromerfassungsfunktion.

Ein derartiger Fehlerstromanalysator ist beispielsweise aus der US 6,097,580 bekannt. Er ist für einen sehr speziellen Anwendungsfall ausgelegt, nämlich zur Überwachung von Geräten, wie Waschmaschinen oder Kühlschränken, bei denen auch im fehlerfreien Normalbetrieb Erdströme auftreten können. Diese sind von den im Fehlerfall auftretenden Fehlerströmen zu unterscheiden. Dieser spezielle Fehlerstromanalysator kann nicht ohne weiteres zur Fehlerstrom-Überwachung eines anderen elektrischen Versorgungsnetzes verwendet werden.

Ein anderer Fehlerstromanalysator mit einer Fourier-Transformationseinheit und einer frequenzselektiven Auswertung ist in der DE 102 37 342 A1 beschrieben.

Zur Fehlerstrom-Überwachung eines elektrischen Versorgungsnetzes kommt üblicherweise ein netzspannungsunabhängiger Fehlerstrom-Schutzschalter (= FI-Schutzschalter; Typ A) oder ein netzspannungsabhängiger Differenzstrom-Schutzschalter (= DI-Schutzschalter; Typ B) zum Einsatz. Ersterer ist zur Erfassung von Wechselfehlerstrom und pulsierendem Gleichfehlerstrom, letzterer zusätzlich auch zur Erfassung von glattem Gleichfehlerstrom ausgelegt. Aufgrund dieser erweiterten Stromerfassungseigenschaften wird der zweite Schutzschaltertyp auch allstromsensitiv bezeichnet. Er ist allerdings aufwändiger in der Realisierung und deshalb relativ teuer.

Ein allstromsensitiver Schutzschalter nach dem Oberbegriff von Anspruch 1 ist aus der EP-A-1267467 bekannt.

Eine Aufgabe der Erfindung besteht deshalb darin, einen Fehlerstromanalysator der eingangs bezeichneten Art anzugeben, der sich flexibel einsetzen und mit einem vergleichsweise geringen Aufwand realisieren lässt.

Diese Aufgabe wird gelöst durch die Merkmale des unabhängigen Patentanspruchs 1. Der erfindungsgemäße Fehlerstromanalysator ist dadurch gekennzeichnet, dass die Auswertemittel, falls das niederfrequente Teilsignal einen Niederfrequenzgrenzwert überschreitet, ausgelegt sind, zur Ermittlung einer ersten kurzen Signalprobe des niederfrequenten Teilsignals, zur Ermittlung eines Effektivwerts der ersten kurzen Signalprobe sowie zum Vergleich des Effektivwerts mit einem unteren und einem oberen Effektivgrenzwert und zu einer daraus abgeleiteten Entscheidung über das Vorliegen eines Fehlerstroms.

Bei dem erfindungsgemäßen Fehlerstromanalysator sind die Auswertemittel also für eine mehrstufige, insbesondere zunächst zweistufige Überwachung ausgelegt. In der ersten kontinuierlich durchgeführten Überwachungsstufe wird der Zeitverlauf des niederfrequenten Teilsignals ständig auf ein Überschreiten eines vorab bestimmbaren Niederfrequenzgrenzwerts überprüft. Solange das niederfrequente Teilsignal unterhalb dieses Niederfrequenzgrenzwerts bleibt, wird diese Überwachung fortgesetzt. Alternativ oder ergänzend zur Momentanwertüberwachung kann auch eine sehr kurze Signalprobe, die insbesondere kürzer als die erste kurze Signalprobe ist und die beispielsweise eine Zeitdauer von etwa 1 ms aufweist, ausgewertet und überwacht werden. Hierzu wird ein Mittelwert dieser sehr kurzen Signalprobe errechnet. Insgesamt fallen im Rahmen der ersten kontinuierlich durchgeführten Überwachungsstufe keine (rechen-) zeitintensiven Schritte an, zu deren Realisierung anderenfalls Hardware- und/oder Software-Ressourcen zur Verfügung gestellt werden müssten.

Erst wenn das niederfrequente Teilsignal den Niederfrequenzgrenzwert überschreitet, sehen die Auswertemittel eine genauere Analyse-Prozedur vor, indem eine Signalprobe des niederfrequenten Teilsignals ermittelt und näher untersucht wird. Diese Signalprobe erstreckt sich über eine vergleichsweise kurze Zeitspanne, insbesondere über eine Periodendauer der Netzfrequenz (= 50 Hz oder 60 Hz) des zu überwachenden elektrischen Netzes. Überschreitet ein für diese Signalprobe ermittelter Effektivwert einen oberen Effektivgrenzwert, wird in den Auswertemitteln auf das Vorliegen eines Fehlerstroms entschieden und am Ausgang des Fehlerstromanalysators ein entsprechendes Signal zur Verfügung gestellt. Dies erfolgt sehr schnell, insbesondere innerhalb einer Zeitspanne entsprechend dem Zweifachen der Netzperiodendauer. Bevorzugt ist eine Zeitspanne von höchstens 30 ms.

Damit entspricht der Fehlerstromanalysator den Anforderungen, die bei einer Netzüberwachung an eine Fehlerstrom-Erkennung und eine Abschaltung des Fehlerstroms gestellt werden. Er kann flexibel eingesetzt werden. Insbesondere ist er nicht wie der bekannte Fehlerstromanalysator auf einen speziellen Anwendungsfall beschränkt.

Darüber hinaus umfasst der Fehlerstromanalysator im Wesentlichen gängige Komponenten, weshalb er mit geringem Aufwand hergestellt werden kann. So reicht es aus, dass der Summenstromwandler zur Erfassung von Wechselfehlerstrom und pulsierendem Gleichfehlerstrom entsprechend den Typ A-Anforderungen ausgelegt ist. Die Auswertemittel ermöglichen dennoch eine Erfassung von Fehlerströmen, die ansonsten in einem Typ A-Fehlerstrom-Schutzschalter nicht detektiert werden können. Auch die Auswertemittel enthalten nur eine gängige programmierbare Logik-Baugruppe oder eine ebenso gängige Mikroprozessor- oder Mikrocontroller-Baugruppe. Der Aufwand zur Realisierung des Fehlerstromanalysators hält sich also in überschaubaren Grenzen.

Vorteilhafte Ausgestaltungen des erfindungsgemäßen Fehlerstromanalysators ergeben sich aus den Merkmalen der von Anspruch 1 abhängigen Ansprüche.

Günstig ist eine Variante, bei der insbesondere zur Ermittlung des Effektivwerts ein Integrator oder eine Fourier-Transformationseinheit vorgesehen ist. Beide können als festverdrahtete Elektronikschaltung oder auch als Software-Modul, das auf einer programmierbaren Hardware-Baugruppe abläuft, realisiert sein. Der Effektivwert lässt sich mittels einer Integration sehr einfach bestimmen. Gleiches gilt für eine Fourier-Transformation, die insbesondere als eine DFT (Discrete Fourier Transformation) oder FFT (Fast Fourier Transformation) ausgebildet sein kann. Der Effektivwert kann dann - abgesehen von einem ggf. erforderlichen multiplikativen Faktor - einfach als Amplitude des relevanten Frequenzwerts abgelesen werden. Eine Integration und eine Fourier-Transformation sind gängige Verfahren der Signalverarbeitung.

Weiterhin können die Auswertemittel zur Ermittlung und Auswertung einer zweiten Signalprobe des niederfrequenten Teilsignals ausgelegt sein, wobei die zweite Signalprobe länger ist als die erste Signalprobe und insbesondere auch die erste Signalprobe mit umfasst. Mittels der zweiten längeren Signalprobe kann eine genauere Auswertung erfolgen. Insbesondere ergibt sich bei der Durchführung einer FFT eine höhere Frequenzauflösung, so dass sich ein höherer Informationsgehalt entnehmen lässt. Die Auswertung der zweiten Signalprobe kann neben einer Fourier-Transformation wiederum eine Effektivwertbindung umfassen. Wenn die zweite längere Signalprobe die erste Signalprobe als Teilabschnitt enthält, ist sichergestellt, dass beide Signalproben einen im Wesentlichen gleichen Zustand des zu überwachenden Netzes betreffen. Eine plötzliche Änderung der Verhältnisse im zu überwachenden elektrischen Netz kann dann zu keiner Verfälschung der Auswerteergebnisse führen. Vorzugsweise enthalten die Auswertemittel einen Speicher, in dem stets ein gewisser Zeitabschnitt des zu analysierenden niederfrequenten Teilsignals hinterlegt ist. Dieser Speicher ist insbesondere nach Art eines Schieberegisters ausgebildet, bei dem eingangsseitig der aktuelle Wert eingeschrieben und ausgangsseitig der älteste noch hinterlegte Wert überschrieben wird.

Gemäß einer anderen bevorzugten Variante ist die Filtereinheit auch zur Selektion eines hochfrequenten Teilsignals des Ausgangssignals ausgelegt. Insbesondere umfasst die Filtereinheit also auch einen Hochpass, genau wie für die Erfassung des niederfrequenten Teilsignals ein Tiefpass vorgesehen sein kann. Verglichen mit dem niederfrequenten Teilsignal enthält das hochfrequente Teilsignal andere, ebenfalls auswertbare Informationen über das Vorliegen eines Fehlerstroms. Es lässt sich deshalb ebenfalls zur Detektion eines Fehlerstroms einsetzen. Die Ermittlung und Auswertung des hochfrequenten Teilsignals kann bedarfsgesteuert, also wenn es die Analyse des niederfrequenten Teilsignals erforderlich erscheinen lässt, oder kontinuierlich erfolgen.

Bei einer weiteren günstigen Variante sind die Auswertemittel so ausgelegt, dass sie eine Entscheidung über das Vorliegen eines Fehlerstroms anhand der zweiten Signalprobe und des hochfrequenten Teilsignals ableiten. Zusammen mit den aus der ersten Signalprobe bereits gewonnenen Informationen ergibt sich dann ein immer genaueres Bild über den Fehlerstrom.

Vorteilhaft ist es außerdem auch, wenn die Auswertemittel zur Ermittlung eines Fehlerstrom-Typs ausgelegt sind. Dies erfolgt insbesondere wiederum anhand der beiden Signalproben und des hochfrequenten Teilsignals. Der Fehlerstromanalysator erkennt dann nicht nur, dass ein Fehlerstrom vorliegt, sondern auch, um welchen Typ es sich handelt. Dies erleichtert die Suche nach dem Fehlerort im überwachten, elektrischen Netz.

Vorzugsweise ist eine Anzeigeeinheit zur Anzeige des ermittelten Fehlerstrom-Typs vorgesehen. Dadurch ist der Fehlerstromanalysator besonders bedienerfreundlich. Alternativ oder optional können die Informationen über den Fehlerstrom-Typ auch als Datensignal an einem Ausgang des Fehlerstromanalysators zur Verfügung gestellt werden.

Bei einer anderen Variante beinhaltet der Fehlerstromanalysator einen Temperatursensor und die Auswertemittel sind zur Kompensation von Temperatureinflüssen ausgelegt. Die verschiedenen Komponenten des Fehlerstromanalysators können einen Temperaturgang aufweisen, der sich nachteilig auf die Erfassungsgenauigkeit auswirken kann. Die jeweiligen Temperaturgänge lassen sich vorab ermitteln und bei Kenntnis der aktuellen Temperatur während des Betriebes kompensieren. Dadurch erhöht sich die Erfassungsgenauigkeit.

Vorzugsweise umfasst der Fehlerstromanalysator außerdem Mittel zur Selbstkalibrierung. Insbesondere enthält er einen Stromgenerator, mittels dessen der Summenstromwandler mit einem simulierten, also gezielt einstellbaren und deshalb bekannten, Fehlerstrom beaufschlagt werden kann. Das dann erfasste Ausgangssignal kann in Verbindung mit den bekannten Informationen über den simulierten Fehlerstrom zur Kalibrierung des Fehlerstromanalysators verwendet werden. Dadurch lässt sich der Fehlerstromanalysator insbesondere an die aktuellen magnetischen Eigenschaften des verwendeten Summenstromwandlers anpassen. Vor allem Abweichungen im magnetischen Verhalten des Bandkerns sind so zu kompensieren. Die Kalibrierung kann auch automatisiert ablaufen (= Selbstkalibrierung). Mittels eines insbesondere elektronisch steuerbaren Stromgenerators können die verschiedenen Fehlerstrom-Typen ebenso eingestellt werden wie unterschiedliche Fehlerstrom-Amplituden. Dadurch steigt die Qualität der Kalibrierung und die Erfassungsgenauigkeit des Fehlerstromanalysators verbessert sich weiter.

Eine weitere Aufgabe der Erfindung besteht darin, eine Einrichtung mit Fehlerstromerfassungsfunktion anzugeben, bei der sich die Fehlerstromerfassung mit einem vergleichsweise geringen Aufwand realisieren lässt.

Diese Aufgabe wird gelöst durch die Merkmale des Patentanspruchs 10. Die erfindungsgemäße Einrichtung umfasst den erfindungsgemäßen Fehlerstromanalysator sowie eine weitere Einheit zur Veranlassung einer Folgemaßnahme bei einem vom Fehlerstromanalysator detektierten Fehlerstrom. Dabei ist der Fehlerstromanalysator insbesondere als integraler Bestandteil dieser ansonsten weitestgehend beliebig ausgestalten Einrichtung ausgebildet. Aufgrund der bereits beschriebenen einfachen Realisierbarkeit des Fehlerstromanalysators lässt sich auch die Einrichtung insgesamt mit vergleichsweise niedrigem Aufwand herstellen.

Eine vorteilhafte Ausgestaltung der erfindungsgemäßen Einrichtung ergibt sich aus den Merkmalen des von Anspruch 10 abhängigen Anspruchs. Dementsprechend ist die weitere Einheit als Typ A-Fehlerstrom-Schutzschalter, als Typ B-Fehlerstrom-Schutzschalter, als Überspannungsschutzgerät, als Überstromschutzgerät, als Ableitstrommessgerät, als Stromzähler, als Multimeter oder als Frequenzumrichter ausgestaltet. Die aufgezählten Einheiten werden in ihrer Funktionalität um die günstigen Eigenschaften des erfindungsgemäßen Fehlerstromanalysator erweitert. Die Vielfalt der möglichen Anwendungsfälle dokumentiert auch die hohe Flexibilität des erfindungsgemäßen Fehlerstromanalysators.

Weitere Merkmale, Vorteile und Einzelheiten der Erfindung ergeben sich aus der nachfolgenden Beschreibung von Ausführungsbeispielen anhand der Zeichnung. Es zeigt:
- FIG 1: ein Ausführungsbeispiel einer Fehlerstrom- Schutzeinrichtung mit einem integrierten netz- spannungsabhängigen Fehlerstromanalysator,
- FIG 2: ein Ablaufdiagramm einer im Fehlerstromanalysa- tor gemäß FIG 1 vorgenommenen Fehlerstrom- Überwachung und -Analyse und
- FIG 3: eine Tabelle mit verschiedenen Fehlerstrom- Typen.

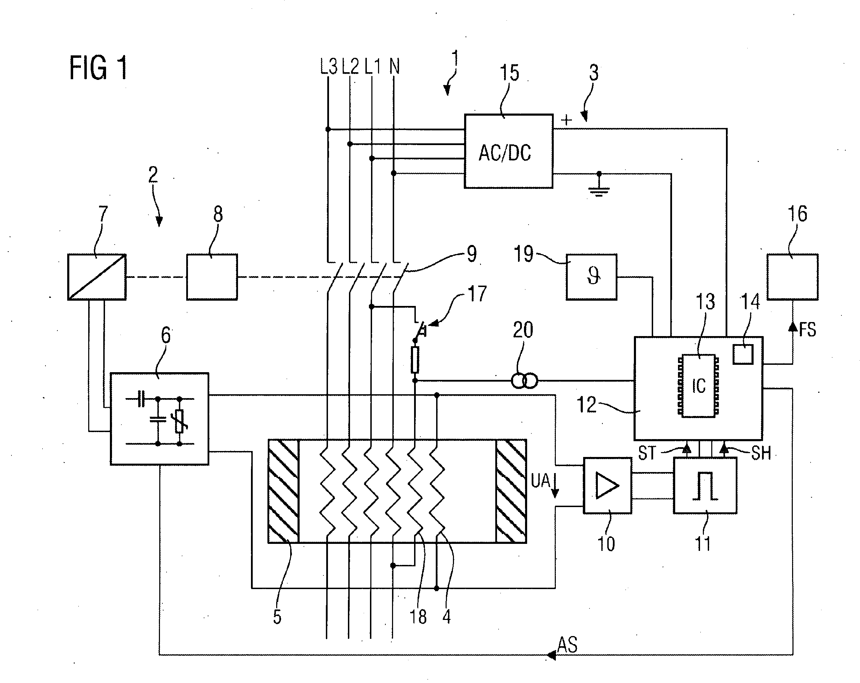

In FIG 1 ist ein Ausführungsbeispiel einer Fehlerstrom-Schutzeinrichtung 1 mit einer netzspannungsunabhängigen Erfassungseihheit 2 und einem netzspannungsabhängigen Fehlerstromanalysator 3, die parallel an eine Sekundärwicklung 4 eines Summenstromwandlers 5 angeschlossen sind. Der Fehlerstromanalysator 3 ist integraler Bestandteil der Fehlerstrom-Schutzeinrichtung 1. Die Fehlerstrom-Schutzeinrichtung 1 dient zur Fehlerstrom-Überwachung eines elektrischen Netzes, das im Ausführungsbeispiel vier elektrische Leiter, nämlich drei Phasenleiter L1, L2 und L3 sowie einen Neutralleiter N, umfasst. Die vier Leiter bilden die Primärwicklungen des Summenstromwandlers 5.

Bei der netzspannungsunabhängigen Erfassungseinheit 2 handelt es sich um einen Typ A-FI-Schutzschalter, der zur Detektion von Wechselfehlerstrom und pulsierendem Gleichfehlerstrom bestimmt ist. Auch der Summenstromwandler 5 ist dementsprechend ausgelegt.

Der Eingang der Erfassungseinheit 2 ist durch eine passive Auswerteschaltung 6 gebildet. Ein Ausgang der Auswerteschaltung 6 ist elektrisch an ein Relais 7 mit einem Haltemagnet angeschlossen. Der Haltemagnet des Relais 7 steht in mechanischer Wirkverbindung mit einem als Energiespeicher wirkenden Schaltschloss 8, das seinerseits eine mechanische Verbindung zu einem Schaltwerk 9 aufweist. Letzteres umfasst im Ausführungsbeispiel vier schaltbare Unterbrechungskontakte, von denen jeweils einer in einem der elektrischen Leiter des Netzes angeordnet ist.

Der Fehlerstromanalysator 3 umfasst eingangsseitig einen Verstärker 10, der elektrisch mittels einer Filtereinheit 11 an eine elektronische Auswerteeinheit 12 angeschlossen ist. Die Filtereinheit 11 ist als Filter-Bank ausgeführt. Sie umfasst einen nicht näher gezeigten Tiefpass und einen ebenfalls nicht näher gezeigten Hochpass. Außerdem kann optional auch mindestens ein Bandpass vorgesehen sein. Alternativ kann auch ein gesteuertes, in seiner Durchlasscharakteristik variabel einstellbares Analogfilter vorgesehen sein. Außerdem kann die Filtereinheit 11 bei einem nicht gezeigten Ausführungsbeispiel als numerisches Filter in die elektronische Auswerteeinheit 12 integriert sein.

Die Auswerteeinheit 12 umfasst verschiedene Komponenten, von denen lediglich eine programmierbare Logik-Baugruppe 13 und ein Speicher 14 schematisiert angedeutet sind. Eingangsseitig ist ein Analog-Digitalwandler (A/D-Wandler) vorgesehen. Anstelle der Logik-Baugruppe 13 kann in einem anderen Ausführungsbeispiel auch eine Mikroprozessor-Baugruppe zum Einsatz kommen.

Zur elektrischen Energieversorgung ist die Auswerteeinheit 12 mit einem Netzteil 15 verbunden, das an die vier elektrischen Leiter des Netzes angeschlossen ist und einen AC/DC-Wandler enthält.

Die Auswerteeinheit 12 ist zur Darstellung von Informationen über den erkannten Fehlerstrom an eine Anzeigeeinheit 16 angeschlossen. Außerdem ist eine elektrische Signalverbindung zwischen der Auswerteeinheit 12 und der Auswerteschaltung 6 zur Übermittlung eines Auslösesignals AS vorgesehen.

Die Fehlerstrom-Schutzeinrichtung 1 enthält weiterhin eine Prüfeinheit 17, mit einem nicht näher bezeichneten Handtaster und einer im Summenstromwandler 5 angeordneten Prüfwicklung 18. Grundsätzlich ist die im Ausführungsbeispiel manuell zu betätigende Prüfeinheit 17 auch in einer nicht gezeigten elektronisch gesteuerten Ausführungsform zu realisieren.

Als optionale Komponenten umfasst der Fehlerstromanalysator 3 einen Temperatursensor 19 sowie einen Kalibrierstrom-Generator 20. Beide sind an die Auswerteeinheit 12 angeschlossen. Der Kalibrierstrom-Generator 20 hat außerdem auch eine elektrische Verbindung zu der Prüfwicklung 18.

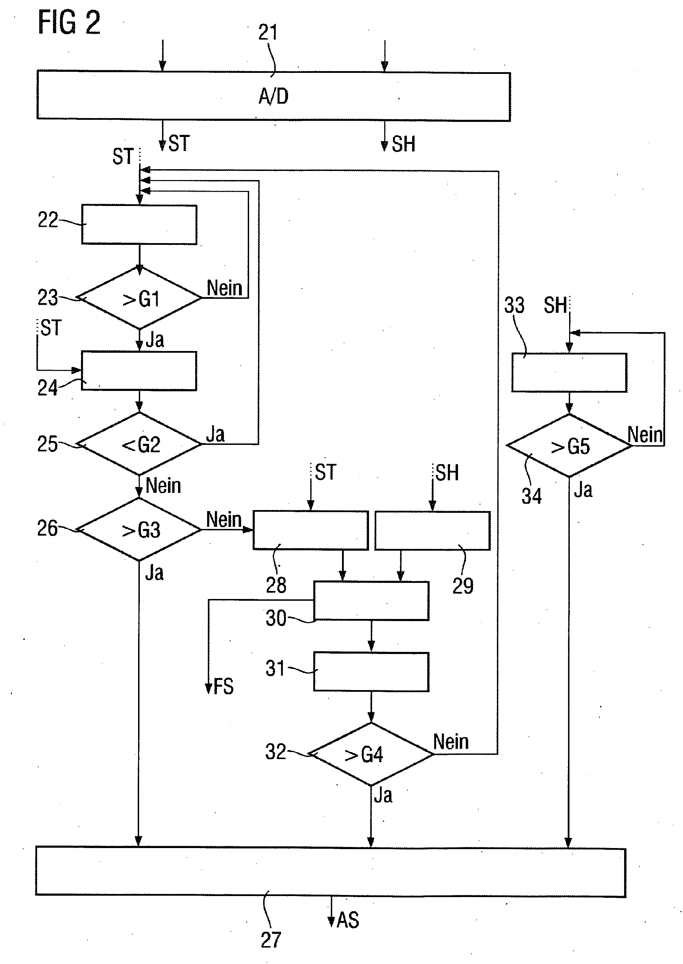

Im Folgenden wird unter Bezugnahme auf das in FIG 2 gezeigte Ablaufdiagramm die Funktionsweise des Fehlerstromanalysators 3 näher beschrieben.

Die Filtereinheit 11 zerlegt ein am Verstärker 10 anstehendes Ausgangssignal UA der Sekundärwicklung 4 in mehrere spektrale Bestandteile. Der Tiefpass extrahiert ein niederfrequentes Teilsignal ST und der Hochpass ein hochfrequentes Teilsignal SH. Das niederfrequente Teilsignal ST umfasst Frequenzen bis zu einer Tiefpassgrenzfrequenz von 1 kHz. Das hochfrequente Teilsignal SH umfasst Frequenzen ab einer Hochpassgrenzfrequenz von 1 kHz. Grundsätzlich können bei anderen Ausführungsbeispielen auch andere Grenzfrequenzen vorgesehen sein. Gleichfalls ist es möglich, dass diese Werte während des Betriebs verändert werden. Dadurch lässt sich eine Frequenzgangsempfindlichkeit gezielt einstellen.

Die Auswerteeinheit 12 erfüllt die wesentlichen Hauptfunktionen des Fehlerstromanalysators 3. In ihr werden die Eingangssignale, also mindestens das niederfrequente Teilsignal ST und das hochfrequente Teilsignal SH analysiert, ein Vorliegen eines Fehlerstroms erkannt, die Art des Fehlerstroms bestimmt und die Entscheidung, einen Auslösebefehl abzusetzen, getroffen.

Gemäß dem in FIG 2 wiedergegebenen Ablaufdiagramm erfolgt in der Auswerteeinheit 12 zunächst ein A/D-Wandlungsschritt 21, in dem das niederfrequente Teilsignal ST und das hochfrequente Teilsignal SH digitalisiert werden. Danach wird in einem Überwachungsschritt 22 zunächst ausschließlich das digitalisierte niederfrequente Teilsignal ST betrachtet. Der zeitliche Verlauf des niederfrequenten Teilsignals ST wird erfasst und überwacht. In einem folgenden Vergleichsschritt 23 wird überprüft, ob der jeweilige Momentanwert des niederfrequenten Teilsignals ST über einem Niederfrequenzgrenzwert G1 liegt. Wenn nicht, führt die Auswerteeinheit 12 für den nächsten Momentanwert des niederfrequenten Teilsignals ST erneut einen Überwachungsschritt 22 aus. Der Niederfrequenzgrenzwert G1 hat im Ausführungsbeispiel einen Wert von 20% des Scheitelwerts des Nennfehlerstroms, für den die Fehlerstrom-Schutzeinrichtung 1 ausgelegt ist.

Falls der Niederfrequenzgrenzwert G1 dagegen überschritten ist, wird in einem Analyseschritt 24 eine kurze Signalprobe des niederfrequenten Teilsignals ST ermittelt und näher untersucht. Bei der kurzen Signalprobe handelt es sich um einen Abschnitt des Signalverlaufs, der sich über eine bestimmte Zeitspanne erstreckt, im Ausführungsbeispiel über eine Zeitspanne von 20 ms entsprechend einer Periodendauer bei einer Netzfrequenz von 50 Hz. Im Analyseschritt 24 wird außerdem ein Effektivwert der kurzen Signalprobe ermittelt. Dies erfolgt entweder mittels einer Integration über die Zeitspanne der kurzen Signalprobe oder mittels einer FFT-Operation, aus deren Ergebnis der Effektivwert als Amplitude beim Frequenzanteil der Netzfrequenz abgelesen werden kann.

Der so ermittelte Effektivwert der kurzen Signalprobe wird in einem folgenden Vergleichsschritt 25 darauf hin überprüft, ob er einen unteren Effektivgrenzwert G2 unterschreitet. Ist dies der Fall, kehrt die Auswerteeinheit 12 zur Standardüberwachung gemäß Überwachungsschritt 22 zurück. Wenn nicht, wird in einem weiteren Vergleichsschritt 26 überprüft, ob der Effektivwert über einem oberen Effektivgrenzwert G3 liegt. Trifft dies zu, wird in einem Auslöseschritt 27 ein Auslösesignal AS abgesetzt. Der untere und obere Effektivgrenzwert G2 bzw. G3 hat im Ausführungsbeispiel einen Wert von 20% bzw. 200% des Effektivwerts des Nennfehlerstroms.

Liegt der Effektivwert der kurzen Signalprobe in einem undefinierten Zwischenbereich zwischen dem unteren Effektivgrenzwert G2 und dem oberen Effektivgrenzwert G3, ist eine detailliertere Untersuchung mit zunächst zwei weiteren Analyseschritten 28 und 29 vorgesehen.

Im Analyseschritt 28 wird eine längere Signalprobe des niederfrequenten Teilsignals ST ermittelt. Diese umfasst die kurze Signalprobe aus dem Analyseschritt 24 als Teilabschnitt. Die längere Signalprobe hat im Ausführungsbeispiel eine Dauer von 100 ms. Die die kurze Signalprobe umfassende längere Signalprobe wird dem Speicher 14 entnommen. Sie hat einen höheren Informationsgehalt als die kurze Signalprobe. Dies zeigt sich auch bei der Durchführung einer FFT, deren resultierendes Frequenzsignal eine Frequenzauflösung von 10 Hz hat. Im Vergleich dazu ist mit der kurzen Signalprobe gemäß Analyseschritt 24 nur eine Frequenzauflösung von 50 Hz zu erzielen. Neben einer FFT-Berechnung kann im Analyseschritt 28 auch für die lange Signalprobe eine Effektivwertbestimmung mittels Integration erfolgen.

In dem parallel zum Analyseschritt 28 durchgeführten Analyseschritt 29 wird auf das digitalisierte hochfrequente Teilsignal SH zurückgegriffen. Dessen Analyse erfolgt vorzugsweise mittels Integration einer sehr kurzen, beispielsweise 1 ms oder 2 ms langen, Signalprobe oder mittels Effektivwertbestimmung anhand eines Gleichrichters mit einem RC-Glied. Alternativ oder ergänzend kann auch eine FFT errechnet werden.

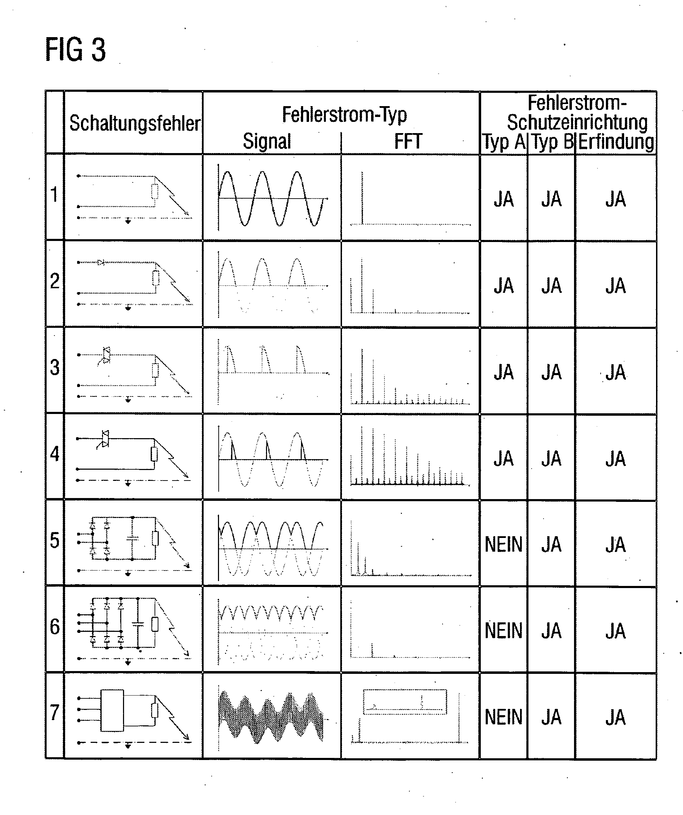

Die in den beiden Analyseschritten 28 und 29 gewonnenen zusätzlichen Informationen werden in einem folgenden Typerkennungsschritt 30 zur Erkennung des aktuell vorliegenden Fehlerstrom-Typs verwendet. Im Ausführungsbeispiel werden sieben Fehlerstrom-Typen unterschieden, die insbesondere bei einem mittels eines Frequenzumrichters angesteuerten Elektromotors auftreten können und die tabellarisch in FIG 3 wiedergegeben sind. Die Detektion erfolgt anhand der in der folgenden Tabelle aufgelisteten Kriterien:

| Fehlerstrom-Typ | 1. Erkennungskriterium | 2. Erkennungskriterium | 3. Erkennungskriterium |
|---|---|---|---|
| 1 | FFT-Impuls bei f_{N} | | |
| 2 | FFT-Impuls bei f_{N} und bei 2f_{N} | **Î**_{fN} / **Î**_{2fN} > 2,2 | |
| 3 | FFT-Impuls bei f_{N}, bei 2f_{N} und bei 3f_{N} | 1,15 ≤ **Î**_{fN} /**Î**_{2fN} ≤1,3 | |
| 4 | | **Î**_{fN} / **Î**_{2fN} < 1,15 | |
| 5 | | **Î**_{fN} / **Î**_{2fN} > 1,3 | |
| 6 | FFT-Impuls bei 3f_{N} und bei 6f_{N} | 2 ≤ **Î**_{3fN} /**Î**_{6fN} ≤ 5 | **Î**_{fN} / **Î**_{3fN} < 0,2 |
| 7 | FFT-Impuls bei 3f_{N} und bei f_{U} | **Î**_{3fN} / **Î**_{6fN} <2 oder **Î**_{3fN} /**Î**_{6fN} > 5 | **Î**_{fH} / **Î**_{3fN} > 0,2 |

Hierbei bezeichnet f_{N} eine Netzfrequenz (z.B. 50 oder 60 Hz), f_{U} eine Umrichterfrequenz, f_{H} eine Hochfrequenz (z.B. Taktfrequenz), **Î**_{fN} einen Wert des FFT-Impulses bei der Netzfrequenz f_{N}, **Î**_{xfN} einen Wert des FFT-Impulses bei der x-fachen Netzfrequenz xf_{N} mit x ∈ [2,3,6], und **Î**_{fH} einen Wert des FFT-Impulses bei der Hochfrequenz f_{H}.

Die Prüfung der in der vorstehenden Tabelle genannten Erkennungskriterien erfolgt von oben nach unten und dann von links nach rechts. Begonnen wird also mit einer Prüfung im FFT-Spektrum vorhandenen Frequenzanteile bei f_{N}, 2f_{N}, 3f_{N}, 6f_{N}, f_{U} und f_{H} entsprechend dem ersten Erkennungskriterium. Danach folgt eine detailliertere Auswertung der vorhandenen Frequenzanteile gemäß dem zweiten und dann dem dritten Erkennungskriterium, so dass letztendlich eine Aussage über den aktuell vorliegenden Fehlerstrom-Typ getroffen werden kann.

Die so gewonnene Information über den aktuellen Fehlerstrom-Typ wird in einem folgenden Korrekturschritt 31 zur Bestimmung eines korrigierten Fehlerstrom-Effektivwerts I_{RMS} auf Basis der Resultate der Analyseschritte 28 und 29 herangezogen.

Je nach erkanntem Fehlerstrom-Typ 1 bis 7 wird der korrigierte Fehlerstrom-Effektivwert I_{RMS} anhand der in der folgenden Tabelle genannten Korrekturfaktoren (für die Fehlerstrom-Typ 1 bis 6) oder Berechnungsvorschrift (für den Fehlerstrom-Typ 7) ermittelt:

| Fehlerstrom-Typ | Korrekturfaktor / Berechnungsvorschrift |
|---|---|
| 1 | **I**_{RMS} / **Î**₁ = 0,71 |
| 2 | **I**_{RMS} / **Î**₁ = 1,00 |
| 3 | **I**_{RMS} / **Î**₁ = 1,20 |
| 4 | **I**_{RMS} / **Î**₁ = 1,67 |
| 5 | **I**_{RMS} / **Î**₁ = 1,67 |
| 6 | **I**_{RMS} / **Î**₁ = 4,20 |
| 7 | I_{RMS} = 0,71 · (**Î**₁ /G_{Max} +**Î**_{fU} /G_{U}) |

Hierbei bezeichnet **Î**₁ einen Wert des in Frequenzrichtung ersten FFT-Impulses (also beispielsweise bei der einfachen oder dreifachen Netzfrequenz f_{N} bzw. 3f_{N}), **Î**_{fU} einen Wert des FFT-Impulses bei der Umrichterfrequenz f_{U}, G_{Max} einen Gewichtungsfaktor des FFT-Impulses mit dem höchsten Amplitudenwert und G_{U} einen Gewichtungsfaktor des FFT-Impulses bei der Umrichterfrequenz f_{U}. Die Gewichtungsfaktoren G_{Max} und G_{U} geben eine in der IEC-Norm 479-2 definierte Gefährdung des Menschen durch einen Fehlerstrom in Abhängigkeit von der Frequenz an.

Am Ende des Korrekturschritts 31 liegt ein korrigierter Fehlerstrom-Effektivwert I_{RMS} vor, anhand dessen in einem anschließenden Vergleichsschritt 32 entschieden wird, ob ein Korrektureffektivgrenzwert G4 überschritten ist oder nicht. Trifft dies zu, wird der Auslöseschritt 27 durchgeführt und ein Auslösesignal AS erzeugt. Falls nicht, kehrt die Auswerteeinheit 12 zur Standard-Überwachung gemäß Überwachungsschritt 22 zurück. Der Korrektureffektivgrenzwert G4 hat im Ausführungsbeispiel einen Wert von 75% des Effektivwerts des Nennfehlerstroms.

Nach Durchlaufen des Typerkennungsschritts 30 sind innerhalb der Auswerteeinheit 12 Informationen über den erkannten Fehlerstrom-Typ vorhanden, die auch anderweitig von Interesse sein können. So lassen sie sich auch zur Lokalisierung des Fehlerorts verwenden. Deshalb wird im Typerkennungsschritt 30 auch ein Fehlerstromsignal FS erzeugt, das diese Informationen über den erkannten Fehlerstrom-Typ enthält. Es wird der Anzeigeeinheit 16 zur Visualisierung zugeführt.

Parallel zu der vorstehend beschriebenen Analyse und Bewertung, die im Wesentlichen auf dem niederfrequenten Teilsignal ST beruht, erfolgt optional auch eine von der Niederfrequenz-Auswertung unabhängige kontinuierliche Überwachung des hochfrequenten Teilsignals SH. Es können nämlich auch Fehlerströme auftreten, die sich nur aus hochfrequenten Anteilen zusammensetzen und die mittels des optionalen Hochfrequenz-Parallelzweigs erkannt werden. Diese Überwachungsfunktion verhindert eine unzulässige Erhitzung der überwachten Geräte oder Einrichtungen. Sie dient folglich in erster Linie dem Brandschutz.

Das hochfrequente Teilsignal SH wird also insbesondere auch in einem Analyseschritt 33, der im Wesentlichen analog zu dem Analyseschritt 29 abläuft, erfasst und aufbereitet. Die Ergebnisse dienen in einem nachfolgenden Vergleichsschritt 34 als Basis für eine Entscheidung, ob ein Hochfrequenzgrenzwert G5 überschritten ist oder nicht. Falls ja, folgt der Auslöseschritt 27, falls nein, wird ein erneuter Analyseschritt 33 durchgeführt. Der Hochfrequenzgrenzwert G5 hat im Ausführungsbeispiel einen Wert von 1000% des Effektivwerts des Nennfehlerstroms, wobei mit 300 mA eine absolute Obergrenze für den Hochfrequenzgrenzwert G5 vorgesehen ist.

Aufgrund der beschriebenen Analyse und Bewertung ist der Fehlerstromanalysator 3 in der Lage, einen hohen Fehlerstrom sehr rasch, das heißt in weniger als 30 ms zu erkennen. Das Auslösesignal AS wird dann unmittelbar nach einer positiven Entscheidung im Vergleichsschritt 26 an die passive Auswerteschaltung 6 der Erfassungseinheit 2 zur Veranlassung einer entsprechenden Schalthandlung weitergeleitet.

Darüber hinaus kann der Fehlerstromanalysator 3 auch Fehlerstrom-Typen erkennen, bei denen die Typ A-Erfassungseinheit 2 ansonsten keine die elektrischen Leiter unterbrechenden Schalthandlung vorgenommen hätte. Die Erfassungseinheit 2 alleine ist nämlich nicht in der Lage, einen Fehlerstrom mit einem nicht vernachlässigbaren Gleichanteil oder einen Fehlerstrom, der sich aus einer Vielzahl verschiedener Frequenzanteile, insbesondere auch hoher Frequenzanteile, zusammensetzt, zu erfassen. Obwohl auch die Fehlerstrom-Schutzeinrichtung 1 im Wesentlichen nur Komponenten eines Typ A-Fehlerstrom-Schutzschalters beinhaltet, können dennoch auch die vorstehend genannten schwierig zu erfassenden Fehlerstrom-Typen erkannt werden. Dies war bislang nur mittels der erheblich aufwändigeren und teureren Typ B-Fehlerstrom-Schutzschalter möglich.

Das verbesserte Detektionsvermögen des erfindungsgemäßen Fehlerstromanalysators 3 und der ihn umfassenden erfindungsgemäßen Fehlerstrom-Schutzeinrichtung 1 geht aus dem in FIG 3 gezeigten tabellarischen Vergleich der Auslösefunktionen verschiedener Fehlerstrom-Schutzeinrichtungen hervor. Es wird nach mit den Nummern 1 bis 7 bezeichneten Fehlerstrom-Typen unterschieden. Diese können bei Frequenzumrichtern auftreten, welche beispielsweise zum Anschluss von Elektromotoren eingesetzt werden.

Die Fehlerstrom-Typen mit den Nummern 5 und 6 weisen einen hohen Gleichanteil auf und können deshalb von einem Typ A-Fehlerstrom-Schutzschalter nicht erkannt werden. Gleiches gilt für den mit Nummer 7 bezeichneten Fehlerstrom-Typ, der einen sehr hochfrequenten Anteil aufweist und somit außerhalb des Erfassungsbereichs eines Typ A-Fehlerstrom-Schutzschalters liegt. Dagegen sind sowohl ein - teuerer - Typ B-Schutzschalter als auch die - preiswertere - Fehlerstrom-Schutzeinrichtung 1 in der Lage, die drei genannten Fehlerstrom-Typen sicher zu erkennen.

Der vorstehend beschriebene Aufbau und die beschriebene Wirkungsweise der Fehlerstrom-Schutzeinrichtung 1 und des Fehlerstromanalysators 3 sind beispielhaft zu verstehen. Alternative Ausführungsformen sind möglich.

So kann zwischen der Filtereinheit 11 und der Auswerteeinheit 12 mindestens ein Effektivwertgleichrichter vorgesehen sein. Die im Rahmen der Auswerteeinheit 12 ausgewerteten Effektivwerte werden dann bereits vor der Analog/Digital-Wandlung erzeugt. Weiterhin können die Erfassungseinheit 2 und der Fehlerstromanalysator 3 an jeweils eine eigene Sekundärwicklung des Summenstromwandlers 5 angeschlossen sein oder auch eine eigene passive Auswerteschaltung und ein eigenes Relais mit Haltemagnet umfassen. Ebenso ist es möglich, dass der Fehlerstromanalysator 3 mehrere programmierbare Logik-Baugruppen enthält, die jeweils verschiedene Mess- und Analysefunktionen wahrnehmen. Mögliche weitere Funktionen sind beispielsweise ein Überspannungsschutz, ein Überstromschutz, eine Netzfrequenzmessung, eine Selbstüberwachung oder eine Hinterlegung und Verwaltung der Historie.

Grundsätzlich kann der Fehlerstromanalysator 3 anstelle in der Fehlerstrom-Schutzreinrichtung 1 auch in einer anderen Einrichtung oder in einem anderen Gerät eingesetzt werden. Er weist diesbezüglich eine hohe Flexibilität auf. Beispiele sind ein Typ B-Fehlerstrom-Schutzschalter, ein Frequenzumrichter, ein Multimeter, ein Stromzähler oder ein Ableitstrommessgerät.

## Patentansprüche

1. Fehlerstromanalysator zur Erfassung eines Fehlerstroms in einem elektrischen Netz mit mehreren elektrischen Leitern (L1, L2, L3, N) umfassend
a) einen Summenstromwandler (5), dessen Primärwicklungen durch die elektrischen Leiter (L1, L2, L3, N) gebildet sind, und der sekundärseitig ein Ausgangssignal (UA) liefert, und
b) an den Summenstromwandler (5) angeschlossene Auswertemittel (10, 11, 12) zur Auswertung des Ausgangssignals (UA), wobei
c) die Auswertemittel (10, 11, 12) eine Filtereinheit (11) zur Selektion mindestens eines niederfrequenten Teilsignals (ST) des Ausgangssignals (UA) umfassen, und wobei
d) die Auswertemittel (10, 11, 12) ausgelegt sind zur Überwachung des niederfrequenten Teilsignals (ST) auf Überschreiten eines Niederfrequenzgrenzwerts (G1),
**dadurch gekennzeichnet, dass** bejahendenfalls die Auswertemittel weiterhin ausgelegt sind,
d1) zur Ermittlung einer ersten kurzen Signalprobe des niederfrequenten Teilsignals (ST),
d2) zur Ermittlung eines Effektivwerts der ersten kurzen Signalprobe sowie
d3) zum Vergleich des Effektivwerts mit einem unteren und einem oberen Effektivgrenzwert und zu einer daraus abgeleiteten Entscheidung über das Vorliegen eines Fehlerstroms.

2. Fehlerstromanalysator nach Anspruch 1, **dadurch gekennzeichnet, dass** insbesondere zur Ermittlung des Effektivwerts ein Integrator oder eine Fourier-Transformationseinheit vorgesehen ist.

3. Fehlerstromanalysator nach Anspruch 1, **dadurch gekennzeichnet, dass** die Auswertemittel (10, 11, 12) ausgelegt sind zur Ermittlung und Auswertung einer zweiten Signalprobe des niederfrequenten Teilsignals (ST), wobei die zweite Signalprobe länger ist als die erste Signalprobe und insbesondere die erste Signalprobe mit umfasst.

4. Fehlerstromanalysator nach Anspruch 1, **dadurch gekennzeichnet, dass** die Filtereinheit (11) auch zur Selektion eines hochfrequenten Teilsignals (SH) des Ausgangssignals (UA) ausgelegt ist.

5. Fehlerstromanalysator nach Anspruch 3 und 4, **dadurch gekennzeichnet, dass** die Auswertemittel (10, 11, 12) zur Ableitung einer Entscheidung über das Vorliegen eines Fehlerstroms anhand der zweiten Signalprobe und des hochfrequenten Teilsignals (SH) ausgelegt sind.

6. Fehlerstromanalysator nach Anspruch 1, **dadurch gekennzeichnet, dass** die Auswertemittel (10, 11, 12) zur Ermittlung eines Fehlerstrom-Typs ausgelegt sind.

7. Fehlerstromanalysator nach Anspruch 6, **dadurch gekennzeichnet, dass** eine Anzeigeeinheit (16) zur Anzeige des ermittelten Fehlerstrom-Typs vorgesehen ist.

8. Fehlerstromanalysator nach Anspruch 1, **dadurch gekennzeichnet, dass** ein Temperatursensor (19) vorgesehen ist und die Auswertemittel (10, 11, 12) ausgelegt sind zur Kompensation von Temperatureinflüssen ausgelegt.

9. Fehlerstromanalysator nach Anspruch 1, **dadurch gekennzeichnet, dass** Mittel zur Selbstkalibrierung, insbesondere ein Stromgenerator (20) zur Beaufschlagung des Summenstromwandlers (5) mit einem simulierten Fehlerstrom, vorgesehen sind.

10. Einrichtung mit Fehlerstromerfassungsfunktion umfassend den Fehlerstromanalysator (3) nach einem der vorhergehenden Ansprüche und eine weitere Einheit (2) zur Veranlassung einer Folgemaßnahme bei einem vom Fehlerstromanalysator (3) detektierten Fehlerstrom.

11. Einrichtung nach Anspruch 10, **dadurch gekennzeichnet, dass** die weitere Einheit als Typ A-Fehlerstrom Schutzschalter (2), als Typ B-Fehlerstrom Schutzschalter, als Überspannungsschutzgerät, als Überstromschutzgerät, als Ableitstrommessgerät, als Stromzähler, als Multimeter oder als Frequenzumrichter ausgestaltet ist.

## Claims

1. Fault current analyser for detecting a fault current in an electrical network having a plurality of electrical conductors (L1, L2, L3, N), said analyser comprising
a) a summation current transformer (5), the primary windings of which are formed by the electrical conductors (L1, L2, L3, N) and which supplies an output signal (UA) on the secondary side, and
b) evaluation means (10, 11, 12) connected to the summation current transformer (5) for the purpose of evaluating the output signal (UA), wherein
c) the evaluation means (10, 11, 12) include a filter unit (11) for selecting at least one low-frequency sub-signal (ST) of the output signal (UA), and wherein
d) the evaluation means (10, 11, 12) are embodied for the purpose of monitoring the low-frequency sub-signal (ST) for exceeding a low-frequency limit value (G1),
**characterised in that**
in the affirmative case the evaluation means are further embodied
d1) for determining a first short signal sample of the low-frequency sub-signal (ST),
d2) for determining a root mean square value of the first short signal sample and
d3) for comparing the root mean square value with a lower and an upper root mean square limit value and for reaching a decision derived therefrom concerning the presence of a fault current.

2. Fault current analyser according to claim 1,
**characterised in that** an integrator or a Fourier transform unit is provided in particular for the purpose of determining the root mean square value.

3. Fault current analyser according to claim 1,
**characterised in that** the evaluation means (10, 11, 12) are embodied for the purpose of determining and evaluating a second signal sample of the low-frequency sub-signal (ST), wherein the second signal sample is longer than the first signal sample and in particular also includes the first signal sample.

4. Fault current analyser according to claim 1,
**characterised in that** the filter unit (11) is also embodied for selecting a high-frequency sub-signal (SH) of the output signal (UA).

5. Fault current analyser according to claim 3 and 4,
**characterised in that** the evaluation means (10, 11, 12) are embodied for deriving a decision concerning the presence of a fault current on the basis of the second signal sample and the high-frequency sub-signal (SH).

6. Fault current analyser according to claim 1,
**characterised in that** the evaluation means (10, 11, 12) are embodied for the purpose of determining a fault current type.

7. Fault current analyser according to claim 6,
**characterised in that** a display unit (16) is provided for displaying the determined fault current type.

8. Fault current analyser according to claim 1,
**characterised in that** a temperature sensor (19) is provided and the evaluation means (10, 11, 12) are embodied for the purpose of compensating for temperature effects.

9. Fault current analyser according to claim 1,
**characterised in that** means for self-calibration, in particular a current generator (20), are provided for applying a simulated fault current to the summation current transformer (5).

10. Device with fault current detecting function, comprising the fault current analyser (3) according to one of the preceding claims and a further unit (2) for initiating a follow-up action in the event of a fault current being detected by the fault current analyser (3).

11. Device according to claim 10, **characterised in that** the further unit is embodied as a Type A residual current circuit breaker (2), as a Type B residual current circuit breaker, as an overvoltage protection device, as an overcurrent protection device, as a leakage current tester, as an electricity meter, as a multimeter or as a frequency converter.

## Revendications

1. Analyseur de courant de fuite destiné à détecter un courant de fuite dans un réseau électrique comportant plusieurs conducteurs électriques (L1, L2, L3, N), comprenant
a) un transformateur de courant totalisateur (5) dont les enroulements primaires sont formés par les conducteurs électriques (L1, L2, L3, N) et qui fournit du côté secondaire un signal de sortie (UA), et
b) des moyens d'évaluation (10, 11, 12) raccordés au transformateur de courant totalisateur (5) et destinés à évaluer le signal de sortie (UA),
c) lesdits moyens d'évaluation (10, 11, 12) comprenant une unité de filtrage (11) destinée à sélectionner au moins un signal partiel basse fréquence (ST) du signal de sortie (UA), et
d) lesdits moyens d'évaluation (10, 11, 12) étant conçus pour surveiller le signal partiel basse fréquence (ST) quant au dépassement d'une valeur limite basse fréquence (G1),
**caractérisé en ce que**, dans l'affirmative, lesdits moyens d'évaluation sont conçus en outre
d1) pour déterminer un premier échantillon de signal court du signal partiel basse fréquence (ST),
d2) pour déterminer une valeur effective du premier échantillon de signal court, ainsi que
d3) pour comparer la valeur effective avec une valeur limite effective inférieure et supérieure et pour en déduire une décision sur la présence d'un courant de fuite.

2. Analyseur de courant de fuite selon la revendication 1, **caractérisé en ce qu'**un intégrateur ou une unité de transformation de Fourier est prévu(e), notamment pour déterminer la valeur effective.

3. Analyseur de courant de fuite selon la revendication 1, **caractérisé en ce que** les moyens d'évaluation (10, 11, 12) sont conçus pour déterminer et évaluer un second échantillon de signal du signal partiel basse fréquence (ST), le second échantillon de signal étant plus long que le premier échantillon de signal et englobant notamment le premier échantillon de signal.

4. Analyseur de courant de fuite selon la revendication 1, **caractérisé en ce que** l'unité de filtrage (11) est conçue également pour sélectionner un signal partiel haute fréquence (SH) du signal de sortie (UA).

5. Analyseur de courant de fuite selon la revendication 3 et 4, **caractérisé en ce que** les moyens d'évaluation (10, 11, 12) sont conçus pour déduire une décision sur la présence d'un courant de fuite à l'aide du second échantillon de signal et du signal partiel haute fréquence (SH).

6. Analyseur de courant de fuite selon la revendication 1, **caractérisé en ce que** les moyens d'évaluation (10, 11, 12) sont conçus pour déterminer un type de courant de fuite.

7. Analyseur de courant de fuite selon la revendication 6, **caractérisé en ce qu'**une unité d'affichage (16) est prévue pour afficher le type de courant de fuite déterminé.

8. Analyseur de courant de fuite selon la revendication 1, **caractérisé en ce qu'**un capteur de température (19) est prévu et **en ce que** les moyens d'évaluation (10, 11, 12) sont conçus pour compenser des effets de température.

9. Analyseur de courant de fuite selon la revendication 1, **caractérisé en ce que** des moyens d'autocalibrage sont prévus, notamment un générateur de courant (20) destiné à alimenter le transformateur de courant totalisateur (5) avec un courant de fuite simulé.

10. Dispositif présentant une fonction de détection de courant de fuite, comprenant ledit analyseur de courant de fuite (3) selon l'une des revendications précédentes et une autre unité (2) destinée à déclencher une mesure consécutive en présence d'un courant de fuite détecté par ledit analyseur de courant de fuite (3).

11. Dispositif selon la revendication 10, **caractérisé en ce que** ladite autre unité est conçue comme disjoncteur à courant de fuite de type A (2), comme disjoncteur à courant de fuite de type B, comme appareil de protection contre les surtensions, comme appareil de protection contre les surintensités, comme appareil de mesure de courant de décharge, comme compteur de courant, comme multimètre ou comme convertisseur de fréquence.
